**Europäisches Patentamt**

**European Patent Office**

**Office européen des brevets**

(19)

(11) Veröffentlichungsnummer : **0 141 159 B1**

(12)

# EUROPÄISCHE PATENTSCHRIFT

(45) Veröffentlichungstag der Patentschrift : 17.05.89

(21) Anmeldenummer : 84110630.5

(22) Anmeldetag : 06.09.84

(51) Int. Cl.⁴ : **H 03 K 19/092, H 03 K 5/02, H 03 K 19/00**

(54) Schnittstellenanordnung.

(30) Priorität : 09.09.83 DE 3332657

(43) Veröffentlichungstag der Anmeldung : 15.05.85 Patentblatt 85/20

(45) Bekanntmachung des Hinweises auf die Patenterteilung : 17.05.89 Patentblatt 89/20

(84) Benannte Vertragsstaaten :
AT BE CH DE FR GB IT LI NL SE

(56) Entgegenhaltungen :
US--A-- 4 301 383
REVIEW OF SCIENTIFIC INSTRUMENTS, Band 54, Nr. 4, April 1983, Seiten 444-453, American Institute of Physics, New York, US; A.M. DUCORPS et al.: "CAMAC controller for a conventional and pseudo-random time-of-flight system"
FUJITSU SCIENTIFIC & TECHNICAL JOURNAL, Band 12, Nr. 1, März 1976, Seiten 1-19, Kawasaki, JP; M. YAMAGUCHI et al.: "Fabrication of 4GHz 8x8 switch matrix for SDMA system"

(73) Patentinhaber : **Siemens Aktiengesellschaft Berlin und München**
**Wittelsbacherplatz 2**
**D-8000 München 2 (DE)**

(72) Erfinder : **Müller, Horst, Dipl.-Ing.**
**Dammmstrasse 11**
**D-8021 Hohenschäftlarn (DE)**

**EP 0 141 159 B1**

**Beschreibung**

Die Erfindung bezieht sich auf eine Schnittstellenanordnung für Digitalsignale.

Für die Übertragung von Digitalsignalen mit Bitraten bis zu 10 Mbit/s enthält das « CCITT-Gelbbuch », Vol. VIII, Fascicle VIII, 1, « Datacommunication over the Telephone Network », Genf, 10. bis 21. November 1980, Seiten 43-55, Empfehlungen V.11 für die folgenden Schnittstellenbedingungen :

Leerlauf-Ausgangsspannungen $U_L \leqslant 6$ V

Ausgangsspannung 100-Ohm-Abschlußwiderstand $U_A \geqslant 2$ V

Kurzschlußstrom $J_K \leqslant 150$ mA

Offsetspannung $U_{offset} \leqslant 3$ V

Generator-Innenwiderstand $R_i \leqslant 100$ $\Omega$

Leckstrom $I_L \leqslant 100$ μA im abgeschalteten Zustand.

Von verschiedenen Herstellern werden sogenannte « linedrivers » hergestellt, die diese Schnittstellenbedingungen erfüllen. Beispielsweise bietet die Firma Texas-Instruments unter der Typenbezeichnung AM 26 LS 31 einen derartigen Baustein an. Dessen Verlustleistung ist jedoch relativ hoch. Sie beträgt ohne Abschlußwiderstand 40 mW ; bei Abschluß mit einem 100-Ohm-Widerstand beträgt die Gesamtverlustleistung 180 mW.

Aus dem Fujitsu Scientific & Technical Journal, Band 12, Nr. 1, März 1976, Seiten 1-19, Abschnitt 5.6 ist schließlich eine Treiberschaltung bekannt. In dieser wird ein TTL-Signal in zwei Differenzverstärkern verstärkt. Die Ausgangssignale werden dann von Emitterfolgern des komplementären Typs geliefert.

Aufgabe der Erfindung ist es, eine die CCITT-Empfehlung V.11 erfüllende Schnittstellenanordnung für ein 64-kbit/s-Datensignal anzugeben, die bei geringem schaltungstechnischem Aufwand eine möglichst geringe Verlustleistung aufweist.

Diese Aufgabe wird für eine Schnittstellenanordnung für Digitalsignale erfindungsgemäß mit einem Eingang, dem ein erster Inverter nachgeschaltet ist, mit einem ersten npn-Transistor, dessen Basis mit dem Ausgang des ersten Inverters, dessen Emitter über einen ersten Widerstand mit einer ersten Ausgangsklemme und dessen Kollektor mit einer Anschlußklemme für eine positive Versorgungsspannung verbunden ist, mit einem ersten pnp-Transistor, dessen Basis mit der Basis des ersten npn-Transistors, dessen Kollektor mit Masse und dessen Emitter mit dem Emitter des ersten npn-Transistors verbunden ist, mit einem zweiten Inverter, dessen Eingang mit dem Ausgang des ersten Inverters verbunden ist, mit einem zweiten npn-Transistor, dessen Basis mit dem Ausgang des zweiten Inverters, dessen Emitter über einen zweiten Widerstand mit einer zweiten Ausgangsklemme und dessen Kollektor mit der Anschlußklemme verbunden ist, und mit einem zweiten pnp-Transistor, dessen Basis mit der Basis des zweiten npn-Transistors, dessen Kollektor mit Masse und dessen Emitter mit dem Emitter des zweiten npn-Transistors verbunden ist, gelöst.

Diese Anordnung ermöglicht es, beispielsweise für das System PCM30F-E&M viele Systemeinsätze in einem Gestell unterzubringen, das eine Stromversorgung von 5,2 A bei + 5 V aufweist.

Vorteilhaft ist es, wenn für den ersten und zweiten Widerstand ein Wert von je 29,4 Ohm gewählt ist.

Vorteilhaft ist es weiter, wenn als Inverter CMOS (Complementary Metall Oxid Silizium)- oder HCMOS (High speed C-MOS)-Bausteine vorgesehen sind.

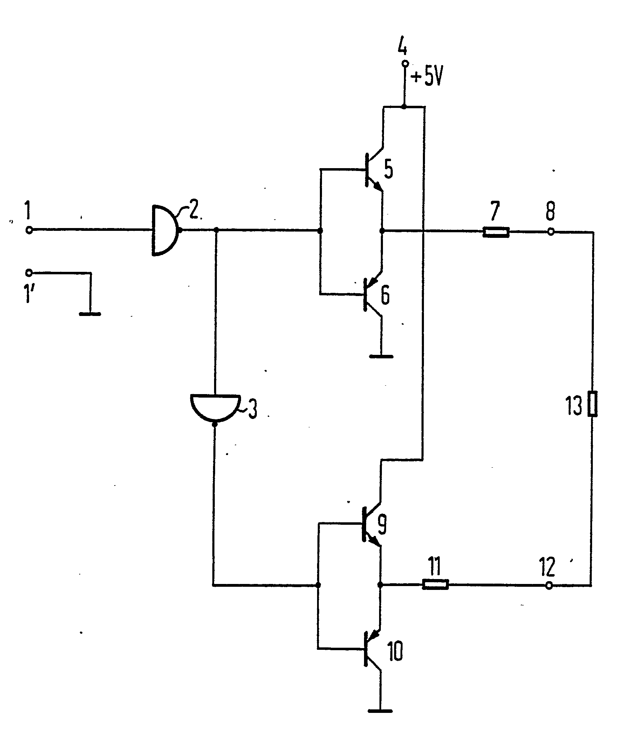

Anhand eines Ausführungsbeispiels in der Figur wird die Erfindung nachstehend näher erläutert.

Die Anordnung enthält zwei Inverter 2 und 3, zwei npn-Transistoren 5 und 9, zwei pnp-Transistoren 6 und 10 und zwei Widerstände 7 und 11. Außerdem sind Eingangsklemmen 1 und 1', Ausgangsklemmen 8 und 12 sowie eine Anschlußklemme 4 für die Betriebsspannung vorhanden. Mit 13 ist ein Abschlußwiderstand bezeichnet.

Die Transistoren werden in Kollektorschaltung betrieben. Es können die Typen BCY 58 und BCY 78 eingesetzt werden.

An den Eingang 1, 1' wird das Datensignal angelegt, welches durch den Inverter 2 invertiert an die Basis der Transistoren 5 und 6 und durch den Inverter 3 nochmals invertiert an die Basen der Transistoren 9 und 10 gelangt. Durch die paarweise Anordnung der npn- und pnp-Transistoren in Kollektorschaltung wird ein sehr niedriger Ausgangswiderstand $< 10$ $\Omega$ für Signalwechsel sowohl in positive als auch in negative Richtung erreicht. Die Spannung an den Emittern folgt der Spannung an den Basen und ist für npn-Transistoren um $U_{BE} \sim 0{,}7$ V und für pnp-Transistoren um $U_{BE} \sim -0{,}7$ V versetzt. Der Abschlußwiderstand 13 im Werte von 100 $\Omega$ ist über die Widerstände 7 und 11 im Werte von 29,4 $\Omega$ jeweils an die Emitter beider Paare angeschlossen.

Werden für die Inverter 2 und 3 CMOS- oder HCMOS-Bausteine verwendet, so entspricht deren Ausgangsspannungshub annähernd der vollen Betriebsspannung $U_B = 5$ V. Die Reihenschaltung zweier Inverter ist damit sinnvoll.

Durch ein log-« 1 »-Signal am Eingang 1 werden die Transistoren 6 und 9 leitend und die Transistoren 5 und 10 gesperrt ; durch ein log-« 0 »-Signal werden die Transistoren 6 und 9 gesperrt und die Transistoren 5 und 10 leitend.

Die Anordnung erfüllt die von CCITT empfohlenen Werte. Sie arbeitet ohne Abschlußwiderstand praktisch verlustleistungsfrei. Bei Abschluß mit einem 100-Ω-Widerstand ergibt sich für $U_{BE} = 0,7$ V und $U_B = 5$ V eine Verlustleistung

$$N = U_B \frac{U_B - 2 \cdot U_{BE}}{100\,\Omega + 2 \cdot 29,4\,\Omega} = 113 \text{ mW}$$

Diese Verlustleistung ist um 67 mW geringer als die des bekannten Bausteins.

## Patentansprüche

1. Schnittstellenanordnung für Digitalsignale mit einem Eingang (1, 1'), dem ein erster Inverter (2) nachgeschaltet ist, mit einem ersten npn-Transistor (5), dessen Basis mit dem Ausgang des ersten Inverters (2), dessen Emitter über einen ersten Widerstand (7) mit einer ersten Ausgangsklemme (8) und dessen Kollektor mit einer Anschlußklemme (4) für eine positive Versorgungsspannung verbunden ist, mit einem ersten pnp-Transistor (6), dessen Basis mit der Basis des ersten npn-Transistors (5), dessen Kollektor mit Masse und dessen Emitter mit dem Emitter des ersten npn-Transistors (5) verbunden ist, mit einem zweiten Inverter (3), dessen Eingang mit dem Ausgang des ersten Inverters (2) verbunden ist, mit einem zweiten npn-Transistor (9), dessen Basis mit dem Ausgang des zweiten Inverters (3), dessen Emitter über einen zweiten Widerstand (11) mit einer zweiten Ausgangsklemme (12) und dessen Kollektor mit der Anschlußklemme (4) verbunden ist, und mit einem zweiten pnp-Transistor (10), dessen Basis mit der Basis des zweiten npn-Transistors (9), dessen Kollektor mit Masse und dessen Emitter mit dem Emitter des zweiten npn-Transistors (9) verbunden ist.

2. Schnittstellenanordnung nach Anspruch 1, dadurch gekennzeichnet, daß für den ersten (7) und den zweiten (11) Widerstand ein Wert von je 29,4 Ohm gewählt ist.

3. Anordnung nach Anspruch 1, dadurch gekennzeichnet, daß als Inverter (2, 3) CMOS- oder HCMOS-Bausteine vorgesehen sind.

## Claims

1. Interface circuit for digital signals having an input (1, 1'), downstream of which a first inverter (2) is connected, having a first npn transistor (5), the base of which is connected to the output of the first inverter (2), the emitter of which is connected via a first resistance (7) to a first output terminal (8), and the collector of which is connected to a connection terminal (4) for a positive supply voltage, having a first pnp transistor (6), the base of which is connected to the base of the first npn transistor (5), the collector of which is connected to earth and the emitter of which is connected to the emitter of the first npn transistor (5), having a second inverter (3), the input of which is connected to the output of the first inverter (2), having a second npn transistor (9), the base of which is connected to the output of the second inverter (3), the emitter of which is connected via a second resistance (11) to the second output terminal (12) and the collector of which is connected to the connection terminal (4), and having a second pnp transistor (10), the base of which is connected to the base of the second npn transistor (9), the collector of which is connected to earth, and the emitter of which is connected to the emitter of the second npn transistor (9).

2. Interface circuits according to Claim 1, characterised in that a value of 29.4 Ohm is selected in each case for the first (7) and the second (11) resistance.

3. Circuit according to Claim 1, characterised in that CMOS or HCMOS devices are provided as inverters (2, 3).

## Revendications

1. Circuit d'interface pour signaux numériques, comportant une entrée (1, 1'), en aval de laquelle est branché un premier inverseur (2), un premier transistor npn (5), dont la base est reliée à la sortie du premier inverseur (2), dont l'émetteur est relié à une première borne de sortie (8) par l'intermédiaire d'une première résistance (7) et dont le collecteur est relié à une borne de raccordement (4) pour une tension d'alimentation positive, un premier transistor pnp (6), dont la base est reliée à la base du premier transistor npn (5), dont le collecteur est relié à la masse et dont l'émetteur est relié à l'émetteur du premier transistor npn (5), un second inverseur (3), dont l'entrée est reliée à la sortie du premier inverseur (2), un second transistor npn (9), dont la base est reliée à la sortie du second inverseur (3), dont l'émetteur est relié à une seconde borne de sortie (12) par l'intermédiaire d'une première résistance (11) et dont le collecteur est relié à la borne de raccordement (4), et un second transistor pnp (10), dont la base est reliée à la base du second transistor npn (9), dont le collecteur est relié à la masse et dont l'émetteur est relié à l'émetteur du second transistor npn (9).

2. Circuit d'interface suivant la revendication 1, caractérisé par le fait que pour la première résistance (7) et pour la seconde résistance (11), on choisit une valeur égale à 29,4 ohms.

3. Circuit suivant la revendication 1, caractérisé par le fait que l'on prévoit, pour constituer les inverseurs (2, 3), des modules CMOS ou HCMOS.